Europäisches Patentamt

European Patent Office

Office européen des brevets

(19)

(11) Veröffentlichungsnummer: **0 576 712 A1**

## (12) EUROPÄISCHE PATENTANMELDUNG

(21) Anmeldenummer: **92111274.4**

(22) Anmeldetag: **03.07.92**

(51) Int. Cl.5: **G01R 33/56**

(43) Veröffentlichungstag der Anmeldung:
**05.01.94 Patentblatt 94/01**

(84) Benannte Vertragsstaaten:
**DE FR IT**

(71) Anmelder: **SIEMENS AKTIENGESELLSCHAFT**
**Wittelsbacherplatz 2**
**D-80333 München(DE)**

(72) Erfinder: **Bruder, Herbert, Dipl.-Phys.**
**Reihendorfer Weg 20**
**W-8551 Hemhofen(DE)**

(54) **Pulssequenz zur schnellen Bildgebung in der Kernspintomographie.**

(57) Mit einer Repetitionszeit (TR), die kleiner als Spin-Gitter-Relaxationszeit (T1) der betrachteten Kernspins ist, werden Hochfrequenzpulse (RF) eingestrahlt. Nach jedem Hochfrequenzpuls (RF) werden durch einen in der Polarität mehrfach wechselnden Auslesegradienten ($G_{RO}$) mehrere Echos gewonnen. Bei dieser Sequenz können trotz langer Repetitionszeiten Bilder in Sekundenbruchteilen gewonnen werden, ohne daß eine spezielle Hardware erforderlich ist.

FIG 1

FIG 2

FIG 3

FIG 4

In der Kernspintomographie sind im wesentlichen drei Methoden zur schnellen Bilderzeugung bekannt, nämlich das FLASH-Verfahren, das FISP-Verfahren und das Echoplanar-Verfahren, jeweils mit entsprechenden Varianten.

Das FLASH-Verfahren ist beispielsweise in der EP-A3-0 191 431 beschrieben. Dabei werden Gradientenechos mit kleinen Flipwinkeln des Hochfrequenzpulses und Repetitionszeiten erzeugt, die wesentlich kleiner als die Spin-Gitter-Relaxationszeiten der zu untersuchenden Kernspins sind. Bei diesem Verfahren werden die Flipwinkel um so kleiner gewählt, je kürzer die Repetitionszeiten sind, je schneller also die Pulssequenz wird. Mit der Verkleinerung der Flipwinkel sinkt auch das Signal/Rauschverhältnis.

In einer besonders schnellen Variante des FLASH-Verfahrens, dem sog. Turbo-FLASH-Verfahren mit extrem kurzen Repetitionszeiten wird vor jeder Meßsequenz die Magnetisierung invertiert, um zu verhindern, daß der T1-Kontrast zusammenbricht. Durch die notwendige Spininversion muß dann allerdings für jede neue Meßsequenz die Einstellung eines Gleichgewichtes der Spins abgewartet werden. Daher ist keine kontinuierliche Messung im dynamischen Gleichgewicht möglich.

Das FISP-Verfahren, das in der US-PS 4,769,603 detailliert beschrieben ist, stellt ebenfalls ein schnelles Gradientenecho-Verfahren dar, bei dem im Unterschied zum FLASH-Verfahren vor jedem Hochfrequenzpuls die Phasencodierung zurückgesetzt wird.

Noch schneller als das FLASH-Verfahren oder FISP-Verfahren ist das sog. Echoplanar-Verfahren, wie es in der EP-A1 0 076 054 beschrieben ist Dabei wird zu Beginn der Pulssequenz ein HF-Anregungspuls unter Einwirkung eines Schichtselektionsgradienten in einer ersten Richtung auf ein Untersuchungsobjekt eingestrahlt. Damit werden Kernspins in einer Schicht des Untersuchungsobjekt angeregt. Nach der Anregung wird ein Phasencodiergradient in einer zweiten Richtung und ein Auslesegradient in einer dritten Richtung eingeschaltet. Erste, zweite und dritte Richtungen stehen senkrecht aufeinander. Der Auslesegradient besteht aus einem Vorphasierpuls sowie aus Teilpulsen wechselnder Polarität. Durch diese wechselnde Polarität des Auslesegradienten werden die Kernspins im Wechsel dephasiert und wieder rephasiert, so daß eine Folge von Kernspinresonanzsignalen entsteht. Dabei werden nach einer einzigen Anregung so viele Signale gewonnen, daß der gesamte Fourier-k-Raum abgetastet wird, d.h. daß die vorliegenden Informationen zur Rekonstruktion eines vollständigen Schnittbildes ausreichen.

Die Kernresonanzsignale werden phasencodiert, im Zeitbereich abgetastet, digitalisiert und die so gewonnenen numerischen Werte in eine Rohdatenmatrix eingetragen. Aus dieser Rohdatenmatrix wird dann aufgrund einer zweidimensionalen Fourier-Transformation ein Bild des Untersuchungsobjektes rekonstruiert.

Der Geschwindigkeitsvorteil des EPI-Verfahrens beruht im wesentlichen darauf, daß nach einer einzelnen Anregung eine Vielzahl von Signalen gewonnen wird, die zur Rekonstruktion eines vollständigen Schnittbildes ausreichen. Sämtliche Signale, die letztlich Gradientenechos darstellen, müssen innerhalb des $T2^*$-Zerfalls gewonnen werden. Daher muß der Auslesegradient sehr schnell bipolar geschaltet werden, so daß eine entsprechende Anlage erhebliche Hardware-Anforderungen gestellt werden.

Aufgabe der Erfindung ist es, eine Pulssequenz derart auszugestalten, daß bei kurzer Meßzeit ein gutes Signal/Rauschverhältnis erzielt wird, wobei die technologischen Anforderungen gegenüber dem EPI-Verfahren geringer bleiben.

Die Aufgabe wird erfindungsgemäß durch die Merkmale des Anspruches 1 gelöst. Vorteilhafte Ausgestaltungen der Erfindung sind in den Unteransprüchen angegeben.

Die Erfindung wird nachfolgend anhand von in den Zeichnungen dargestellten Ausführungsbeispielen näher erläutert. Es zeigen:

FIG 1 bis 4    ein erstes Ausführungsbeispiel einer erfindungsgemäßen Pulssequenz,

FIG 5    eine erste geänderte Sequenz für den Phasencodiergradienten $G_{PC'}$,

FIG 6    eine zweite geänderte Sequenz für den Phasencodiergradienten $G_{PC''}$,

FIG 7    eine erste Alternative zum Einordnung der Kernresonanzsignale S in eine Rohdatenmatrix M,

FIG 8    eine zweite Alternative zum Einordnung der Kernresonanzsignale S in eine Rohdatenmatrix M,

FIG 9    die T2-Gewichtung der Signale in Abhängigkeit von der Zeile der Rohdatenmatrix M;

FIG 10 bis 13    ein zweites Ausführungsbeispiel der erfindungsgemäßen Sequenz.

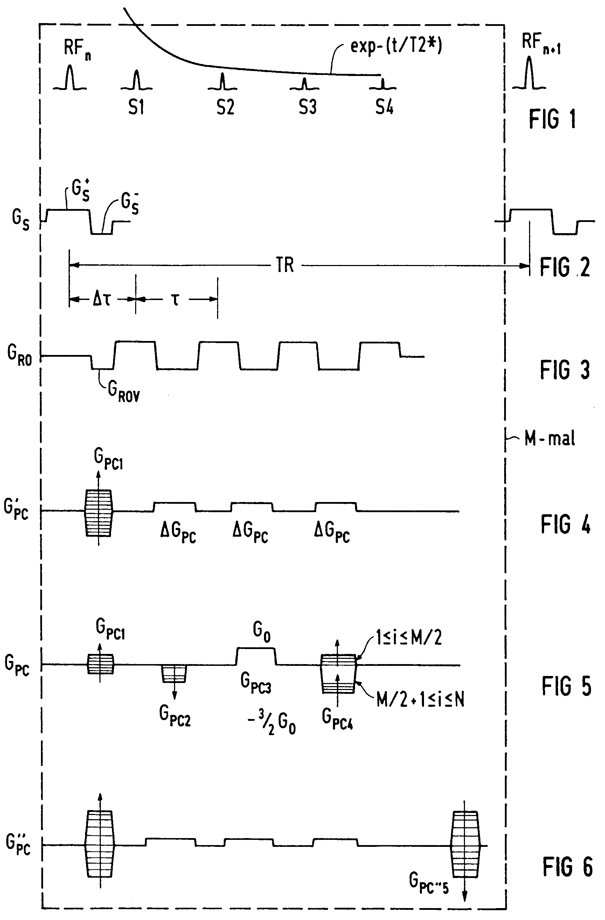

Ein erstes Ausführungsbeispiel der Erfindung wird nachfolgend anhand der Pulssequenz nach den FIG 1 bis 4 erläutert. Unter der Einwirkung eines Schichtselektionsgradienten $G_S^+$ wird ein selektiver Hochfrequenzpuls $RF_n$ eingestrahlt. Anschließend wird der Schichtselektionsgradient $G_S^+$ zu $G_S^-$ in-vertiert, um die durch ihn hervorgehobene Dephasierung wieder aufzuheben. Ferner wird ein negativer Vorphasiergradient $G_{ROV}$ in Ausleserichtung RO eingeschaltet. Schließlich wird der Auslesegradient $G_{RO}$ mehrfach invertiert, wobei bei jedem Teilpuls des Auslesegradient $G_{RO}$ ein Kernresonanzsignal entsteht. Wie beim bereits eingangs erläuterten Echoplanar-Verfahren beruht dies auf aufeinanderfolgenden Dephasierungs- und Rephasierungsvorgängen der Kernspins.

Im dargestellten Beispiel werden nur die unter den positiven Teilpulsen des Auslesegradienten $G_{RO}$ auftretenden Kernresonanzsignale S1 bis S4 ausgelesen. Während der negativen Teilpulse des Auslesegradient $G_{RO}$ werden Phasencodiergradienten $\Delta G_{PC}$ eingeschaltet, auf deren Struktur im folgenden noch näher eingegangen wird.

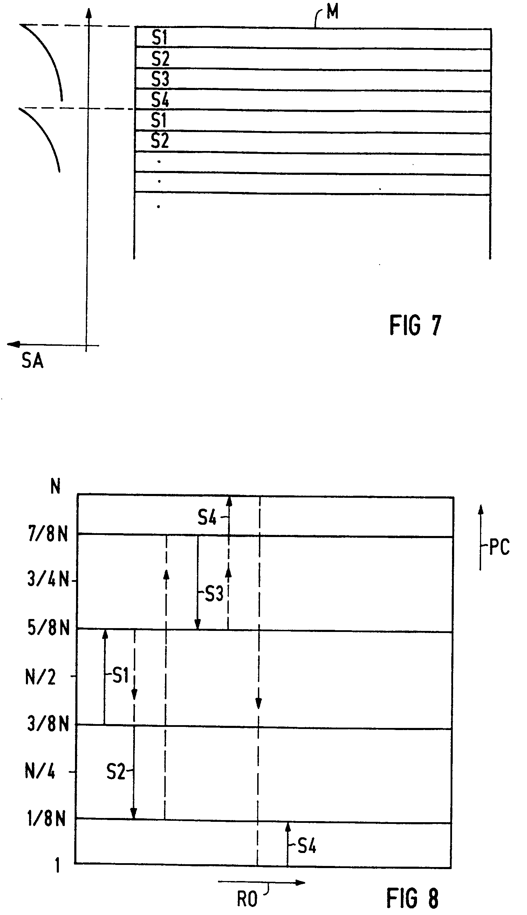

In einem Zeitabstand TR (Repetitionszeit) zum Hochfrequenzpuls $RF_n$ folgt ein weiterer Hochfrequenzpuls $RF_{n+1}$, auf den wiederum die dargestellte Pulssequenz folgt. Der Zeitabstand TR ist kleiner als die Spin-Gitter-Relaxationszeit. Wenn man die dargestellte Pulssequenz M-mal durchführt, so stehen schließlich 4xM Kernresonanzsignale zur Auswertung zur Verfügung. Diese Kernresonanzsignale S werden in herkömmlicher Weise abgetastet, digitalisiert und die so gewonnenen numerischen Werte nach Phasenfaktoren sortiert für jedes Kernresonanzsignal S in eine Zeile einer Rohdatenmatrix gemäß FIG 7 eingetragen. Die Rohdatenmatrix kann man als Meßraum, bei dem im Ausführungsbeispiel vorliegenden zweidimensionalen Fall als Meßdatenebene betrachten. Dieser Meßdatenraum wird in der Kernspintomographie im allgemeinen als "k-Raum" bezeichnet.

Die für die Bilderzeugung notwendigen Informationen über die räumliche Herkunft der Signalbeiträge S ist in den Phasenfaktoren codiert, wobei zwischen dem Ortsraum (also dem Bild) und dem k-Raum mathematisch der Zusammenhang über eine Fourier-Transformation besteht. Es gilt:

$$S(K_x, K_y) = \iint \varrho(x, y) e^{i(K_x x + K_y y)} dx dy$$

Dabei gelten folgende Definitionen:

$$K_x(t) = \gamma \int_{c}^{t} G_{RO}(t')\, dt'$$

$$K_y(t) = \gamma \int_{c}^{t} G_{PC}(t')\, dt'$$

$\gamma$ = gyromagnetisches Verhältnis
$G_{RO}(t')$ = Momentanwert des Auslesegradienten $G_{RO}$
$G_{PC}(t')$ = Momentanwert des Phasencodiergradienten $G_{PC}$
$\rho$ = Kernspindichte.

Bei der in FIG 7 dargestellten Rohdatenmatrix entspricht jede Zeile einem einzelnen Kernresonanzsignal S. Bei schrittweiser Fortschaltung des Phasencodiergradienten $G_{PC}$ erfolgt die Abtastung im k-Raum in aufeinanderfolgenden Zeilen. Zu Beginn jeder Teilsequenz wird jeweils vor dem ersten Kernresonanzsignal $S_1$ ein Phasencodiergradient $G_{PC1}$ eingeschaltet, dessen Gradientenamplitude von Teilsequenz zu Teilsequenz kontinuierlich schrittweise ansteigt. Jeweils vor jedem weiteren Kernresonanzsignal S2 bis S4 wird durch Zuschalten jeweils eines Phasencodiergradienten $\Delta G_{PC}$ die Phase der Kernspins innerhalb der Sequenz schrittweise erhöht, und zwar soweit, daß sie jeweils einer Zeile in der Meßdatenmatrix nach FIG 7 entspricht.

Über mehrere Teilsequenzen betrachtet, führt dies dazu, daß zunächst die vier aufeinanderfolgenden Kernresonanzsignale S1 bis S4 in die vier ersten Zeilen der Meßdatenmatrix eingetragen werden. In der nächsten Teilsequenz wird die Phase der Kernspins durch den Gradienten $G_{PC1}$ soweit fortgeschaltet, daß die nächsten vier Kernresonanzsignale S1 bis S4 in die nächsten vier Zeilen der Meßdatenmatrix eingetragen werden.

Dieses Verfahren hat allerdings folgenden Nachteil: Wie in FIG 1 angedeutet, nimmt die Amplitude der Kernresonanzsignale S1 bis S4 mit dem Zeitabstand t ab dem Hochfrequenzpuls nach der Funktion exp-$(t/T2^*)$ vorab. Dabei ist $T2^*$ die effektive Spin-Spin-Relaxationszeit, also der Zeitkonstante, mit der ein FID-Signal unter Berücksichtigung von Magnetfeldinhomogenitäten abklingt. In FIG 7 ist $T2^*$-abhängige Amplitude über die Zeilen der Meßdatenmatrix schematisch eingetragen und mit SA bezeichnet. Der sich dabei ergebende Amplitudenverlauf über die Zeilen der Meßmatrix kann zu Bildartefakten führen. Dies kann man jedoch im wesentlichen durch Korrektur der T2-Abhängigkeit der Kernresonanzsignale korrigieren. Dazu werden die Kernresonanzsignal S mit dem Faktor

$$\exp[(l-1)\cdot r + \Delta\tau/T2]$$

multipliziert. Dabei ist

- $l = 1...,L$ = Nummer des Kernresonanzsignals innerhalb jeder Teilsequenz
- $L$ = Anzahl der Kernresonanzsignale je Teilsequenz.
- $\Delta\tau$ = Zeitabstand zwischen Hochfrequenzpuls $RF_n$ und erstem Kernresonanzsignal S1
- $\tau$ = Zeitabstand zwischen den einzelnen Kernresonanzsignalen S.

Dies erfordert die Kenntnis der Querrelaxationszeit T2 des Untersuchungsobjektes, z.B. des Herzmuskels.

Wenn aufgrund von Grundfeldinhomogenitäten die effektive Relaxationszeit T2* deutlich kleiner als die vom Untersuchungsobjekt vorgegebenen Querrelaxationszeit T2 ist, so kann man, falls erforderlich, durch Variation die besten Korrekturfaktoren ermitteln.

Bei einer Abänderung der Reihenfolge der Phasencodierschritte entsprechend den FIG 5 und 8 kann man die Vermeidung von Bildartefakten aufgrund der T2-Abhängigkeit der Kernresonanzsignale auch ohne Korrekturfaktoren erreichen. Dazu werden die Kernresonanzsignale nicht nur in der Reihenfolge ihres zeitlichen Auftretens in die Meßmatrix einsortiert, sondern die jeweils ersten, zweiten, dritten bzw. vierten Signale S1 bis S4 in der Reihenfolge des Auftretens nach dem zugeordneten Hochfrequenzsignal $RF_n$ blockweise zusammengefaßt. Die Signale mit der höchsten Amplitude, also die Signale S1, kommen dabei in die mittleren Zeilen der Meßdatenmatrix, da diese Zeilen am stärksten zum Bild beitragen. Die schwächsten Signale, also die Signale S4 jeder Teilsequenz werden entsprechend an die Randzeilen der Meßmatrix verlagert.

In FIG 8 ist schematisch dargestellt, wie man die Kernresonanzsignale S1 bis S4 nacheinander in die Zeilen der Meßmatrix mit N Zeilen einsortiert. Durch den Phasencodiergradient $G_{PC1}$ nach FIG 5 werden die jeweils ersten Signale S1 jeder Meßsequenz so phasencodiert, daß nach Ende der Meßdatenaufnahme alle Signale S1 in einem Zeilenbereich symmetrisch um die Mittelzeile N/2 liegen.

Durch den Zweiten Phasencodiergradienten $G_{PC2}$ nach FIG 5, der von Teilsequenz zu Teilsequenz in negativer Richtung fortgeschaltet wird, werden die jeweils zweiten Signale S2 nach unten fortschreitend in einen Zeilenbereich einsortiert, der von $\frac{3}{8}$ N bis $\frac{1}{8}$ N reicht, wobei die Signale S2 entsprechend ihrer zeitlichen Reihenfolge von oben nach unten einsortiert werden.

Die jeweils dritten Signale S3 werden schließlich durch einen konstanten Phasencodiergradienten $G_{PC3}$ so einsortiert, daß sie in einem Zeilenbereich zwischen $\frac{5}{8}$ N und $\frac{7}{8}$ N zu liegen kommen, und zwar entsprechend ihrer zeitlichen Reihenfolge von oben nach unten.

Die jeweils vierten Signale S4 werden schließlich in zwei Blöcke aufgeteilt, um eine möglichst weitgehende Symmetrie des Amplitudenverlaufes bezüglich der Nullzeile zu erreichen. Die erste Hälfte der Signale S4 wird durch einen von Null beginnend von Teilsequenz zu Teilsequenz in positiver Richtung schrittweise fortgeschalteten Phasencodiergradienten $G_{PC4}$ im Bereich der Zeilen $\frac{7}{8}$ N bis N einsortiert. Wenn man also insgesamt M Teilsequenzen mißt und mit dem Index i die Nummer der Teilsequenz bezeichnet, so werden die Signale $S_{4i}$ für

$$1 \leq i \leq \frac{M}{2}$$

in die Zeilen $\frac{7}{8}$ N bis N einsortiert. Die restlichen Signale S4, also S4i für

$$\frac{M}{2} + 1 \leq N$$

werden in die untersten Zeilen 1 bis $\frac{1}{8}$ N der Meßmatrix einsortiert. Dazu wird für das in Zeile 1 einzusortierende Kernresonanzsignal S4 gemäß FIG 5 der Phasencodiergradient $G_{PC4}$ zunächst in negativer Richtung geschaltet und dann von Teilsequenz zu Teilsequenz der negative Wert schrittweise verändert.

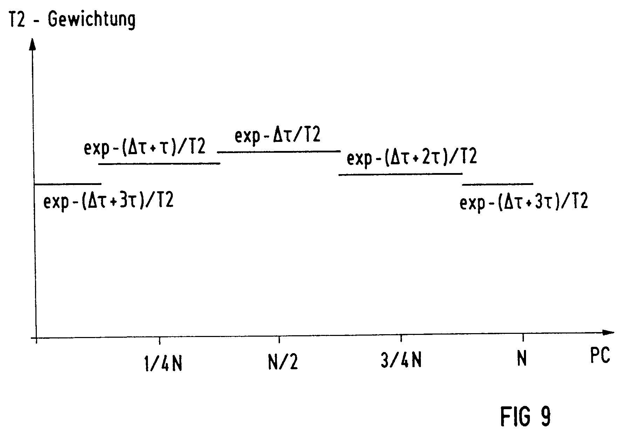

Bei einer Einordnung der Kernresonanzsignale gemäß FIG 8 ergibt sich ein Amplitudenverlauf der Kernresonanzsignale in Abhängigkeit von der Relaxationszeit T2 (also eine T2-Gewichtung) nach FIG 9. Dabei ist, wie in FIG 2 eingezeichnet, der Abstand zwischen Hochfrequenzpuls RF und dem jeweils ersten Kernresonanzsignal S1 mit $\Delta\tau$ und der Abstand zwischen den einzelnen Kernresonanzsignalen S1 bis S4 mit $\tau$ bezeichnet. Die T2-Gewichtung weist damit eine Blockstruktur auf, mit der im Gegensatz zum Ausführungsbeispiel nach FIG 7 Artefakte aufgrund der T2-Abhängigkeit der Signale S1 bis S4 vermieden werden können. Die Fortschaltung der Phasencodierung nach FIG 8 ist so festgelegt, daß möglichst geringe Phasensprünge von Zeile zu Zeile auftreten. Die maximale Phasenänderung aufgrund von Objektbewegun-

EP 0 576 712 A1

gen entspricht dann gerade der Repetitionszeit TR.

Für relativ schnell bewegte Objekte, z.B. das Herz, könnte beim Ausführungsbeispiel nach FIG 8 die Phasenänderung aufgrund von Objektbewegungen dennoch zu Bewegungsartefakten führen, wobei man dann auf das Ausführungsbeispiel nach FIG 7 mit Anwendung von Korrekturfaktoren zurückgreifen könnte. Wenn man dort das Sequenztiming so wählt, daß der zeitliche Abstand zwischen dem letzten Kernresonanzsignal S4i einer Teilsequenz und dem ersten Kernresonanzsignal S1i+1 der nachfolgenden Teilsequenz ungefähr dem Abstand $\tau$ zwischen zwei Kernresonanzsignalen während jeder Teilsequenz entspricht, dann ergibt sich eine maximale Phasenänderung von Fourier-Zeile zu Fourier-Zeile entsprechend dem zeitlichen Abstand $\tau$. Bewegungen werden dann keinen größeren Störeinfluß auf die Bildqualität haben, als dies z.B. bei der bereits eingangs erwähnten Turbo-FLASH-Methode der Fall ist.

Bezüglich der Teilsequenzen ist noch eine Reihe von Modifikationen möglich. So kann z.B. entsprechend FIG 6 die Phasencodierung vor jedem neuen Hochfrequenzpuls RF mit einem Phasencodiergradienten $G_{PC''5}$ zurückgesetzt werden. Dies entspricht der FISP-Sequenz, wie sie in der bereits eingangs erwähnten US-PS 4,769,603 beschrieben ist.

Die auf der FISP-Sequenz beruhende Pulssequenz nach FIG 6 hat gegenüber den auf der FLASH-Sequenz beruhenden Pulssequenz nach den FIG 4 und 5 den Vorteil, daß sie einen echten T2-Kontrast aufweist, der diagnostisch besonders wertvoll ist. Gemäß der Darstellung nach FIG 6 werden die Kernresonanzsignale so phasencodiert, daß sie entsprechend FIG 7 in der Reihenfolge ihres zeitlichen Auftretens in die Zeilen der Meßmatrix einsortiert werden. Selbstverständlich wäre natürlich auch eine Phasencodierung nach FIG 5 möglich, die zu einer Einsortierung der Signale in die Meßmatrix entsprechend FIG 8 führen würde.

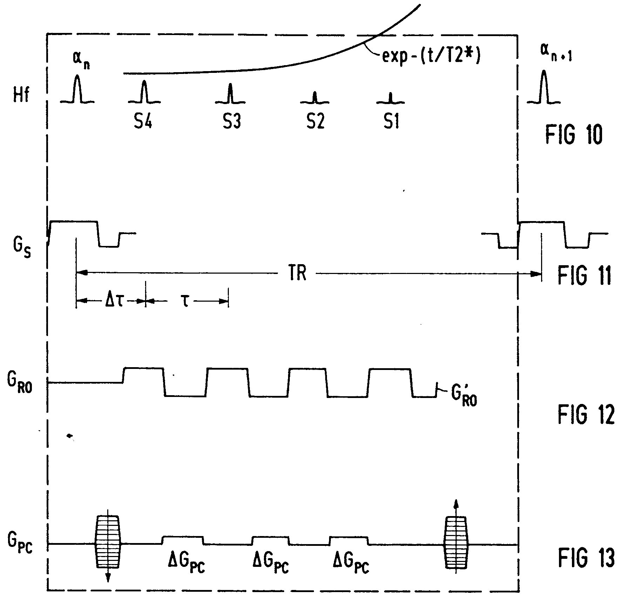

Eine weitere Modifikation der erfindungsgemäßen Pulssequenz ist in den FIG 10 bis 13 dargestellt. Wie in dem Artikel H. Bruder et al "A New Steady-State Imaging Sequence for Simultaneous Acquisition of Two MR Images with Clearly Different Contrasts", Magnetic Resonance in Medicine, 7, S. 35 bis 42 (1988) dargestellt, läßt sich ein dynamisches Gleichgewicht auch dadurch erreichen, daß in einer Folge von Hochfrequenzpulsen mit einer Repetitionszeit kleiner als die Spin-Gitter-Relaxationszeit Signale auch vor jedem Hochfrequenzpuls ausgelesen werden, wobei diese Pulssequenz vielfach als "PSIF"-Sequenz (in Umkehrung des Ausdruckes "FISP") bezeichnet wird. Entsprechend FIG 12 wird dies dadurch erreicht, daß der Vorphasierpuls $G_{ROV}$ nach FIG 3 ersetzt wird durch eine Rephasierung in Richtung des Auslesegradienten $G_{RO}$. Der dazu erforderliche Gradientenpuls ist in FIG 12 mit $G_{RO'}$ bezeichnet. Die erhaltenen Echos sind stark T2-gewichtet. Das unmittelbar dem Hochfrequenzpuls RF vorhergehende Echo S1 weist in diesem Fall die höchste Amplitude auf und der Amplitudenverlauf ist zeitlich gesehen gerade spiegelverkehrt zur Sequenz nach FIG 1. Der Auslesegradient $G_{RO}$ entsprechend FIG 12 bleibt - abgesehen vom bereits erwähnten Vorphasierpuls $G_{RO'}$ - unverändert. Die Sequenz für den Phasencodierer nach FIG 13, die zu einer Einsortierung der Kernresonanzsignale in die Meßmatrix entsprechend FIG 8 führt, ist im Vergleich zu FIG 6 ebenfalls spiegelverkehrt.

Selbstverständlich wäre es auch möglich, den Phasencodiergradienten entsprechend FIG 5, jedoch spiegelverkehrt, zu schalten und die Kernresonanzsignale entsprechend FIG 7 in die Meßmatrix einzusortieren.

Die dargestellte Pulssequenz kann z.B. mit folgenden Parametern durchgeführt werden:
- Repetitionszeit TR = 20 ms
- Zahl M der Teilsequenzen für einen vollständigen Datensatz M = 16
- Zahl der Kernresonanzsignale je Teilsequenz = 4
- Breite eines Pulses des Auslesegradienten $G_{RO}$ $\tau/2$ = 2 ms.

Mit einer derartigen Sequenz kann in weniger als ca. 320 ms eine 128x64 Bildmatrix gemessen werden. Gegenüber Turbo-FLASH-Sequenzen mit gleicher Meßzeit ist die Repetitionszeit TR länger, so daß größere Anregungswinkel für die Hochfrequenzpulse gewählt werden können. Damit erhält man im dynamischen Gleichgewicht ein besseres Signal/Rauschverhältnis

Eine kontinuierliche Erfassung von Datensätzen im dynamischen Gleichgewicht ist möglich, wohingegen bei Turbo-FLASH für jede Aufnahme eine neue Spininversion erfolgen muß und daher zunächst das Gleichgewicht abgewartet werden muß. Durch Variation der Zahl der für jeden Datensatz angewandten Teilsequenzen und der Repetitionszeit TR läßt sich das Signal/Rauschverhältnis und auch der Bildkontrast steuern. Im Gegensatz zum Echoplanar-Verfahren, das besondere Hardwareanforderungen stellt, kann die hier dargestellte Pulssequenz auch auf herkömmlichen MR-Anlagen ohne Hardwareanpassungen realisiert werden.

5

**Patentansprüche**

1.  Pulssequenz für ein Kernspintomographiegerät zur Akquisition von Kernresonanzsignalen aus einem Untersuchungsbereich eines Objektes, das Kerne mit einer vorgegebenen Spin-Gitter-Relaxationszeit (T1) enthält, mit folgenden Verfahrensschritten:
    a) auf den Untersuchungsbereich wirkt ein homogenes Magnetfeld ein, das Spins im Untersuchungsbereich in eine vorgegebene Richtung (z) ausrichtet;
    b) auf den Untersuchungsbereich wird ein Hochfrequenzpuls (RF) zur Einwirkung gebracht, der Spins um eine vorgegebenen Flipwinkel kleiner als 90° aus der vorgegebenen Richtung (z) auslenkt;
    c) nach Ende des Hochfrequenzpulses (RF) wird ein Auslesegradient ($G_{RO}$) mit L Teilimpulsen wechselnder Polarität geschaltet, wobei unter jedem Teilpuls ein Kernresonanzsignal (S) in Form eines Echos entsteht und mindestens ein Teil dieser Signale ausgelesen wird;
    d) vor jedem ausgelesenen Signal (S) wird ein Phasencodiergradient ($G_{PC}$) geschaltet, dessen Richtung senkrecht zur Richtung des Auslesegradienten ($G_{RO}$) ist, wobei jedem ausgelesenen Signal (S) eine andere Phaseninformation aufgeprägt wird.
    e) die Schritte b) bis d) werden M-mal wiederholt, wobei der Abstand zwischen zwei Hochfrequenzpulsen (RF) kleiner als die Spin-Gitter-Relaxationszeit (T1) ist.

2.  Pulssequenz nach Anspruch 1, **dadurch gekennzeichnet,** daß jeder Hochfrequenzpuls (RF) unter der Wirkung eines zum Auslesegradienten und zum Phasencodiergradienten senkrechten Schichtselektionsgradienten ($G_S^+$) eingestrahlt wird und daß die mit dem Schichtselektionsgradienten verursachte Dephasierung durch einen Rephasiergradienten ($G_S^-$) wieder kompensiert wird.

3.  Pulssequenz nach Anspruch 1 oder 2, **dadurch gekennzeichnet,** daß jeder Phasencodiergradient ($G_{PC}$) während der Teilpulse einer ersten Polarität des Auslesegradienten ($G_{RO}$) eingeschaltet wird und daß die während der Teilpulse einer zweiten Polarität entstehenden Kernresonanzsignale (S) ausgelesen werden.

4.  Pulssequenz nach einem der Ansprüche 1 bis 3, **dadurch gekennzeichnet,** daß vor jedem Hochfrequenzpuls (RF) in Phasencodierrichtung ein Gradient ($G_{PC5}$) eingeschaltet wird, mit dem die in Phasencodierrichtung vorhandene Phaseninformation zurückgesetzt wird.

5.  Pulssequenz nach einem der Ansprüche 1 bis 4, **dadurch gekennzeichnet,** daß zwischen jedem Hochfrequenzpuls (RF) und dem ersten darauffolgenden Kernresonanzsignal (S1) ein Vorphasierpuls ($G_{ROV}$) in Richtung des Auslesegradienten eingeschaltet wird.

6.  Pulssequenz nach Anspruch 4, **dadurch gekennzeichnet,** daß vor jedem Hochfrequenzpuls (RF) ein Vorphasierpuls ($G_{RO'}$) in Ausleserichtung eingeschaltet wird.

7.  Pulssequenz nach einem der Ansprüche 1 bis 6, wobei die Kernresonanzsignale (S) abgetastet und digitalisiert werden und wobei die so gewonnenen Meßwerte je Kernresonanzsignal (S) nach Phasenfaktoren sortiert in Zeilen eines Meßmatrix (M) eingetragen werden, **dadurch gekennzeichnet,** daß die Schaltung des Phasencodiergradienten ($G_{PC}$) derart erfolgt, daß zeitlich aufeinanderfolgende Kernresonanzsignal (S) in benachbarten Zeilen der Meßmatrix (M) angeordnet werden.

8.  Pulssequenz nach einem der Ansprüche 1 bis 6, **dadurch gekennzeichnet,** daß die Schaltung des Phasencodiergradienten ($G_{PC}$) derart erfolgt, daß die einzelnen Kernresonanzsignal in der Reihenfolge ihres Auftretens nach den Hochfrequenzpulsen (RF) gruppenweise in aufeinanderfolgende Zeilen der Meßmatrix (M) eingetragen werden.

9.  Pulssequenz nach Anspruch 8, **dadurch gekennzeichnet,** daß die Signale (S1) mit der höchsten Amplitude in die mittleren Zeilen der Meßmatrix (M) eingetragen werden.

FIG 1

FIG 2

FIG 3

FIG 4

FIG 5

FIG 6

FIG 7

FIG 8

8

T2 - Gewichtung

$$\exp-(\Delta\tau+\tau)/T2 \qquad \exp-\Delta\tau/T2$$

$$\exp-(\Delta\tau+2\tau)/T2$$

$$\exp-(\Delta\tau+3\tau)/T2 \qquad\qquad\qquad \exp-(\Delta\tau+3\tau)/T2$$

1/4N          N/2          3/4N          N          PC

FIG 9

FIG 10

FIG 11

FIG 12

FIG 13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 414 318 (NORTH AMERICAN PHILIPS CORPORATION)<br>* Zusammenfassung *<br>* Spalte 6, Zeile 29 - Spalte 9, Zeile 48; Abbildung 4 * | 1-5 | G01R33/56 |
| A | --- | 6-9 | |
| A | DE-A-4 035 410 (SIEMENS AG)<br><br>* Spalte 1, Zeile 56 - Spalte 5, Zeile 32; Abbildungen 2-13 *<br>--- | 1-3,5,7,8 | |
| A | IEEE TRANSACTIONS ON MEDICAL IMAGING<br>Bd. 10, Nr. 1, 1. März 1991, NEW YORK US<br>Seiten 1 - 10<br>G. KASHMAR ET AL. 'CARTESIAN ECHO PLANAR HYBRID SCANNING WITH TWO TO EIGHT ECHOS'<br>* das ganze Dokument *<br>--- | 1 | |
| A | EP-A-0 349 976 (HITACHI, LTD.)<br>* Zusammenfassung *<br>* Seite 5, Zeile 19 - Zeile 55; Abbildung 3 *<br>--- | 1,2,7 | **RECHERCHIERTE SACHGEBIETE (Int. Cl.5)**<br><br>G01R |
| A | EP-A-0 490 528 (GENERAL ELECTRIC COMPANY)<br>* Spalte 3, Zeile 24 - Spalte 4, Zeile 46; Abbildungen 3A,3B *<br><br>----- | 1,2,7 | |

Der vorliegende Recherchenbericht wurde für alle Patentansprüche erstellt

| Recherchenort | Abschlußdatum der Recherche | Prüfer |
|---|---|---|
| DEN HAAG | 12 FEBRUAR 1993 | HORAK G.I. |